(19) Europäisches Patentamt
European Patent Office
Office européen des brevets

(11) Veröffentlichungsnummer: **0 009 742**
**A1**

(12) # EUROPÄISCHE PATENTANMELDUNG

(21) Anmeldenummer: 79103585.0

(22) Anmeldetag: 24.09.79

(51) Int. Cl.$^3$: G 03 G 5/09
H 01 L 31/02

(30) Priorität: 27.09.78 DE 2841925

(43) Veröffentlichungstag der Anmeldung:
16.04.80 Patentblatt 80/8

(84) Benannte Vertragsstaaten:
DE FR GB

(71) Anmelder: BASF Aktiengesellschaft
Carl-Bosch-Strasse 38
D-6700 Ludwigshafen(DE)

(72) Erfinder: Koenig, Ulrich, Dr. Dipl.-Chem.
Londoner Ring 83
D-6700 Ludwigshafen(DE)

(72) Erfinder: Fischer, Martin, Dr. Dipl.-Chem.
Elbingerweg 1
D-6700 Ludwigshafen(DE)

(72) Erfinder: Patsch, Manfred, Dr. Dipl.-Chem.
Fritz-Wendel-Strasse 4
D-6706 Wachenheim(DE)

(54) **Fotoleitfähige Massen auf Basis von Kunststoffen und deren Verwendung zur Herstellung von Filmen und Verbunden.**

(57) Der Erfindung betrifft fotoleitfähige Massen auf Basis von Homo- oder Copolymerisaten, die N-Vinylcarbazol oder dessen kernsubstituierte Vertreter enthalten, und außerdem substituierte, von carbocyclischen aromatischen Grundkörpern abgeleitete Di- und Polyanhydride, -Imide, Di- oder Polyester oder Esterimide enthalten. Besonders bevorzugt werden von den carbocyclischen Aromaten das Benzol, das Naphthalin und insbesondere die Verbindungen, die sich vom Perylen ableiten, angewendet. Die erfindungsgemäß anzuwendenden Sensibilisatoren können auf relativ einfachem Wege wohlfeil hergestellt werden.

Aus den beanspruchten Massen können Filme oder Verbunde aus Filmen mit elektrisch leitenden Unterlagen hergestellt werden, die insbesondere als Fotoleiter in der Electrophotographie, in der Fotowiderstandstechnik, der holografischen Messtechnik, auf dem Mikrofilmgebiet und beim Offsetdruck sowie als Ersatz für Selen in Alarmanlagen, Belichtungsmessern und dergleichen, angewendet werden können.

EP 0 009 742 A1

BASF Aktiengesellschaft O. Z. 0050/033426

## Fotoleitfähige Massen auf Basis von Kunststoffen und deren Verwendung zur Herstellung von Filmen und Verbunden

Die Erfindung betrifft fotoleitfähige Massen auf Basis von Kunststoffen, die eine bestimmte Klasse von Sensibilisatoren enthalten. Als Kunststoffe kommen Poly-N-Vinylcarbazol oder dessen Alkyl-, Halogen-, Alkoxy- oder Dialkylaminoderivate sowie deren Copolymerisate in Betracht.

Fotoleiter verändern bei Bestrahlung mit beispielsweise sichtbarem Licht ihren Ohm'schen Widerstand. Poly-N-Vinylcarbazol ist ein Fotoleiter, der ohne Sensibilisatoren im ultravioletten Bereich des Spektrums absorbiert. Mischt man z.B. eine Lösung von Poly-N-Vinylcarbazol in Tetrahydrofuran mit einer gelben Lösung von 2,4,7-Trinitro-9-fluorenon, in dem selben Lösungsmittel (THF), dann entsteht ein braunschwarzer Donator-Acceptor-Komplex (DA-Komplex). Es ist üblich, DA-Komplexe aus Polyvinylcarbazol und 2,4,7-Trinitro-9-fluorenon in Lösungen herzustellen und durch Ausgießen und Trocknenlassen Filme oder Folien zu erzeugen (vgl. DE-AS 1 068 115).

Aus den US-Patentschriften 3 159 483, 3 232 755 und 3 384 237 sind fotoleitfähige Massen aus Poly-N-Vinylcarbazol und alkylsubstituierten N-Vinylcarbazolen und 2,4,7-Trinitro-9-fluorenon als Sensibilisator (auch als Elektronen-Acceptor bezeichnet) in verschiedenen Mengen-

Vo/Br

verhältnissen von Kunststoff zu Sensibilisator bekannt.

Darüber hinaus sind aus einem Übersichtsartikel von W. Klöpffer in Kunststoffe, 61, (1971), Heft 8, Seiten 533 bis 539, Chloranil, Tetracyanoäthylen und organische Farbstoffe als Sensibilisatoren für Poly-N-Vinylcarbazol bekannt.

Von den bekannten Sensibilisatoren scheint 2,4,7-Trinitro-9-fluorenon im sichtbaren Bereich des Lichtes am wirksamsten zu sein, weshalb dieser Sensibilisator auch technische Anwendung in der Elektrofotografie gefunden hat.

Nachteilig bei der Verwendung von 2,4,7-Trinitro-9-fluorenon ist seine Toxizität und die Tatsache, daß seine Herstellung mit hohem technischen Aufwand verbunden ist.

Es bestand daher die Aufgabe, Sensibilisatoren zu finden, die in der elektrofotografischen Wirksamkeit diesem bekannten Sensibilisator vergleichbar sind, ohne dessen Nachteile aufzuweisen.

Erfindungsgemäß wird diese Aufgabe dadurch gelöst, daß man anstelle der bekannten Sensibilisatoren Di- und Polyanhydride Imide, Di- oder Polyester von Aromaten wie Benzol, Naphthalin und Perylen verwendet.

Die Erfindung betrifft daher fotoleitfähige Massen, enthaltend

a) Homopolymerisate von N-Vinylcarbazol oder dessen kernsubstituierten Halogen-, Alkyl-, Alkoxy- oder Dialkylaminoderivaten oder Mischungen daraus und/oder Copolymerisate mit bis zu 30 Gewichtsprozent an mit N-Vinylcarbazol copolymerisierbaren Monomeren,

b) Sensibilisatoren, sowie

c) gegebenenfalls weitere Zusätze.

Diese Massen sind dadurch gekennzeichnet, daß sie als Sensibilisatoren von durch ein oder mehrere Halogenatome, Nitril- und/oder Nitrogruppen substituierten carbocyclischen aromatischen Grundkörpern abgeleitete

$b_1$-Polyanhydride mit mindestens 2 Anhydridgruppen
$b_2$-Ester von diesen und/oder
$b_3$-davon abgeleitete Imide, die gegebenenfalls am (an den) Stickstoffatom(en) durch $C_1$-$C_8$-Alkyl-, $C_1$-$C_8$-Alkoxy-, $C_1$-$C_8$-Alkoxycarbonylalkyl, substituiert sind.

Für die erfindungsgemäßen fotoleitfähigen Massen kommen Homo- oder Copolymerisate des N-Vinylcarbazols in Betracht, wobei die Copolymerisate bis zu 30 Gewichtsprozent an mit N-Vinylcarbazol copolymerisierbaren Monomeren enthalten können. Als copolymerisierbare Monomere kommen dabei in Betracht:
Styrol, Alkylstyrole, Halogenstyrole, gegebenenfalls Maleinsäureanhydrid, Acrylnitril u. dgl.

Außer Poly-N-Vinylcarbazol können auch die im aromatischen Kern substituierten Poly-N-Vinylalkylcarbazole mit 1 bis 6 C-Atomen im Alkylrest angewendet werden. Außerdem kommen kernhalogenierte, insbesondere chlorierte und bromierte Poly-N-Vinylcarbazole sowie kernsubstituierte Vertreter mit Dialkylaminogruppen in Betracht, in denen die Alkylreste 1 bis 6 C-Atome aufweisen. Auch kernsubstituierte Poly-N-Vinylcarbazole, die Alkoxygruppen mit 1 bis 4 C-Atomen aufweisen, sind geeignet. Schließlich können auch Mischungen der vorstehend genannten Stoffgruppen, d.h. Mischungen aus Homopolymerisaten und Copolymerisaten oder

Mischungen aus Homo- oder Copolymerisaten mit kernsubstituierten Poly-N-Vinylcarbazolen, angewendet werden. Von den vorstehend genannten Polymerisaten werden inbesondere die Homopolymerisate des Poly-N-Vinylcarbazols angewendet. Die Homo- oder Copolymerisate oder die Mischungen dieser mit den vorstehend bezeichneten kernsubstituierten Poly-N-Vinylcarbazolen werden im Sinne der vorliegenden Erfindung auch als Kunststoff bezeichnet.

Poly-N-Vinylcarbazol ist im Handel erhältlich; eine Methode zur Herstellung ist beispielsweise in der US-PS 2 072 465 beschrieben. Weitere Methoden zur Herstellung dieser Verbindung sind in der eingangs genannten Literaturstelle von W. Klöpffer genannt. Bezüglich der mechanisch, thermischen und elektrischen sowie Lösungseigenschaften des Poly-N-Vinylcarbazols sei insbesondere auf die Tabellen 1 und 3 der zitierten Literaturstelle verwiesen.

Als Sensibilisatoren im Sinne der vorliegenden Erfindung kommen von carbocyclischen aromatischen Grundkörpern abgeleitete Polyanhydride mit mindestens 2 Anhydrid-Gruppen sowie deren Ester und die von den Anhydriden abgeleiteten Imide in Betracht. Die carbocyclischen aromatischen Grundkörper können gegebenenfalls substituiert sein. Es können auch Anhydrid-Imidgruppierungen enthaltende Vertreter angewendet werden. Die Polyimide können auch N- substituiert sein.

Die carbocyclischen aromatischen Grundkörper umfassen einfache Aromaten wie Benzol, kondensierte Aromaten wie Naphthalin und lineare mehrkernige Kohlenwasserstoffe, wie Biphenylen, Naphthacen sowie von den höherkondensierten Ringsystemen das Perylen. Als bevorzugte carbocyclische aromatische Grundkörper kommen Benzol, Naphthalin und Perylen in Betracht. Die carbocyclischen aromatischen

Grundkörper enthalten mindestens einen der folgenden Substituenten:
Halogen, wie Chlor oder Brom, sowie das Pseudohalogen Cyan und die Nitrogruppe. In Abhängigkeit von dem verwendeten aromatischen Grundkörper können höchstens zwei (z.B. bei Benzol), bis zu vier (bei Naphthalin) oder bis zu 8 Substituenten (bei Perylen) in das Molekül des Sensibilisators eingebracht werden.

Besonders bevorzugt sind die vom einfachsten aromatischen Grundkörper, dem Benzol abgeleiteten Vertreter wie 3,6-Dichlorbenzol-tetracarbonsäure-1,2,4,5-dianhydrid oder die entsprechenden Diimide. Von Naphthalin als aromatischem Grundkörper abgeleitet, wird bevorzugt das durch 1 bis 4 Halogenatome substituierte Naphthalin-1,4,5,8-tetracarbonsäuredianhydrid für die erfindungsgemäßen fotoleitfähigen Massen angewendet.

Von Perylen als carbocyclischem aromatischen Grundkörper werden bevorzugt die Halogenderivate der nachfolgend genannten Vertreter angewendet:

1. Perylen-3,4,9,10-tetracarbonsäureanhydrid

2. Perylen-3,4,9,10-tetracarbonsäuretetraalkylester (Alkyl = $CH_3$-, $C_2H_5$-)

3. Perylen-3,4,9,10-tetracarbonsäureditetraisopropylester.

Von 1, 2 und 3 werden insbesondere die Derivate bevorzugt, die 2,4,5- oder 6-Chloratome als Substituenten aufweisen oder 2 bis 6 Bromatome als Substituenten tragen. Die Herstellung der Chlor-Verbindungen ist in der DE-OS 2 519 790 beschrieben. Die Br-Verbindungen können analog hergestellt werden.

Besonders bevorzugt werden die Pentachlor-perylen-3,4,9,10-tetracarbonsäure-ester verwendet. Diese Verbindungen werden, wie in der DE-OS 2 512 516 beschrieben, hergestellt.

Ferner werden bevorzugt die Diimide angewendet, die sich von der 3,4,9,10-Tetracarbonsäure des Perylens ableiten, die durch 1 oder mehrere Halogenatome substituiert ist und bevorzugt Methyl, OH-, $-CH_2COOC_2H_5$ oder 2-Cyano-4-chlor--phenyl-als Substituenten an den beiden Stickstoffatomen tragen.

Besonders bevorzugt werden die symmetrisch substituierten Diimide angewendet.

Bei der Herstellung der erfindungsgemäßen fotoleitfähigen Massen sollte beachtet werden, daß das Verhältnis des Kunststoffes (Komponente a) zu dem Sensibilisator ganz bestimmte Bereiche der Zusammensetzung aufweist. Bezogen auf 1 Mol der Monomereneinheit im Poly-N-Vinylcarbazol sollte theoretisch 1 Mol Sensibilisator angewendet werden, um den DA-Komplex zu erhalten. Aus sterischen Gründen wird jedoch dieses Verhältnis in den meisten Fällen nicht erreicht. Das Molverhältnis, ausgedrückt als N-Vinylcarbazol-Monomeres /Sensibilisator liegt für die vorstehend genannten Acceptoren etwa im Bereich von 1 : 2 bis 1 : 0,05, vorzugsweise wird ein Bereich von 1 : 1 bis 1 : 0,5 gewählt.

Die Herstellung der erfindungsgemäßen fotoleitfähigen Massen kann wie folgt erfolgen:

Der Kunststoff, nämlich Poly-N-Vinylcarbazol oder Copolymerisate bzw. aus diesen oder substituierten Vertretern hergestellte Mischungen, ist in Methylenchlorid, Chloroform, Benzol, Toluol, Chlorbenzol, Xylol und Tetrahydro-

furan (THF) löslich. Die Mehrzahl der erfindungsgemäß zu verwendenden Sensibilisatoren sind in diesen Lösungsmitteln ebenfalls löslich. Die erfindungsgemäßen fotoleitfähigen Massen (Donator-Acceptor-Komplexe) aus Kunststoff und Sensibilisator entstehen beim Mischen von Lösungen des Kunststoffs in einem der vorstehend genannten Lösungsmittel mit einer Lösung des Sensibilisators in einem der vorstehend genannten Lösungsmittel, wobei bevorzugt dasselbe Lösungsmittel für Kunststoff und Sensibilisator verwendet wird. Selbstverständlich können auch Kunststoff und Sensibilisator, jeder für sich, in chemisch unterschiedlichen Lösungsmitteln gelöst werden und die Lösungen danach zusammengegeben werden.

Die erfindungsgemäßen fotoleitfähigen Massen können aber auch in Form von Dispersionen in Lösungsmitteln oder Gemischen von Lösungsmitteln gewonnen bzw. erzeugt werden. Aus den Lösungen von Kunststoff und Sensibilisator bzw. aus den Dispersionen sind die fotoleitfähigen Massen auf bekannte Weise durch Entfernen des Lösungsmittels zu gewinnen.

Das vorstehend beschriebene Herstellungsverfahren für die fotoleitfähigen Massen hat gegebenenfalls den Nachteil, daß nur solche Sensibilisatoren Anwendung finden, die in den Lösungsmitteln löslich sind, in denen auch Poly-N-Vinylcarbazol löslich ist. Zur Herstellung von Filmen oder Folien auf metallisch leitenden Unterlagen kann dieses Verfahren deshalb von Nachteil sein, wenn ein geeigneter Sensibilisator in dem für die Lösung von Poly-N-Vinylcarbazol in Frage kommenden Lösungsmittel nicht oder nur begrenzt löslich ist. Dann lassen sich nach dem vorstehend beschriebenen Verfahren nur verdünnte Lösungen der Kunststoff-/Sensibilisator-Mischung herstellen, so daß bei der Herstellung von Folien bzw. Filmen gegebenenfalls

mehrere Verfahrensschritte zum Einbringen einer bestimmten Quantität an Sensibilisator in den Kunststoff erforderlich werden.

Die erfindungsgemäßen Massen können zur Herstellung von Filmen angewendet werden. Die Additionsverbindung aus dem Kunststoff und dem Sensibilisator kann dabei in der Form einer Lösung bzw. Dispersion angewendet werden, wie sie bei der Herstellung der erfindungsgemäßen Massen anfällt. Die Lösung bzw. Dispersion kann nach üblichen Methoden, z.B. durch Vergießen, Sprühen, Tauchen oder mit Hilfe einer Drahtrakel zu Filmen verarbeitet werden.

Als elektrisch leitende Unterlagen für die Herstellung von Filmen aus den erfindungsgemäßen fotoleitfähigen Massen kommen insbesondere Metalle, wie Aluminium, Kupfer und Eisen in Betracht. Ferner sind geeignet:
Die mit elektrischen Leitern beschichteten Gläser, z.B. ein mit Zinnoxid/Indiumoxid beschichtetes Glas. Außerdem können mit Salzen getränkte Papiere als Unterlage verwendet werden. Besonders bevorzugt wird Aluminium als metallisch leitende Unterlage verwendet. Es ist auch möglich, eloxiertes Aluminium bzw. ein Aluminium zu verwenden, dessen Oberfläche mit Sand aufgerauht ist.

Filme oder Verbunde aus solchen Filmen mit elektrisch leitenden Unterlagen können Verwendung finden für die Elektrofotografie, und zwar sowohl bei der Bilderzeugung durch Widerstandsänderung durch Belichtung als auch bei der Bilderzeugung durch Widerstandsänderung bei Anlegen einer Spannung. Ferner kommen die fotoleitfähigen Massen zur Anwendung in der Fotowiderstandstechnik, der holografischen Meßtechnik, auf dem Mikrofilmgebiet und beim Offsetdruck, insbesondere sind die erfindungsgemäßen fotoleitfähigen Massen als Ersatz von Selen in Alarmanlagen,

Belichtungsmessern und dgl. geeignet.

Als Zusätze in Mengen bis zu ca. 25 % Gewichtsprozent, bezogen auf die fotoleitfähige Masse, zu den erfindungsgemäßen Massen sind z.B. Weichmacher zu nennen, von denen bevorzugt solche angewendet werden, die auch für die Weichmachung von Poly-N-Vinylcarbazol angewendet werden. Es seien genannt:
Benzyltetralin, Amylnaphthalin, Phenanthren, Diamylphenyl, Terphenyl, Diäthylphthalat und Dibutylphthalat.

Die Erfindung wird anhand der nachfolgenden Beispiele näher erläutert. Alle in den Versuchen und Beispielen genannten Teile und Prozente beziehen sich, wenn nichts anderes vermerkt ist, auf das Gewicht.

Versuch 1

Herstellung von am N-Atom-substituierten-Dichlortetracarbon-säurediimid

6 g chloriertes, feinkörniges Pyromellithsäure-Dianhydrid (Dichlorbenzoltetracarbonsäure-1,2,4,5-dianhydrid) und 6 g 2-Amino-5-chlorbenzonitril wurden in einem Mörser gemischt und danach in einem Porzellantiegel 1 Stunde lang auf 60°C und danach eine weitere Stunde auf 150°C erwärmt. Im Anschluß daran wurde noch während 1/2 Stunde auf 220°C erhitzt, wobei durch Kondensation ein gelbes Reaktionsprodukt erhalten wurde, das nach dem Abkühlen in der Reibschale zerkleinert wurde. Die Kondensation erfolgte nach dem folgenden Schema:

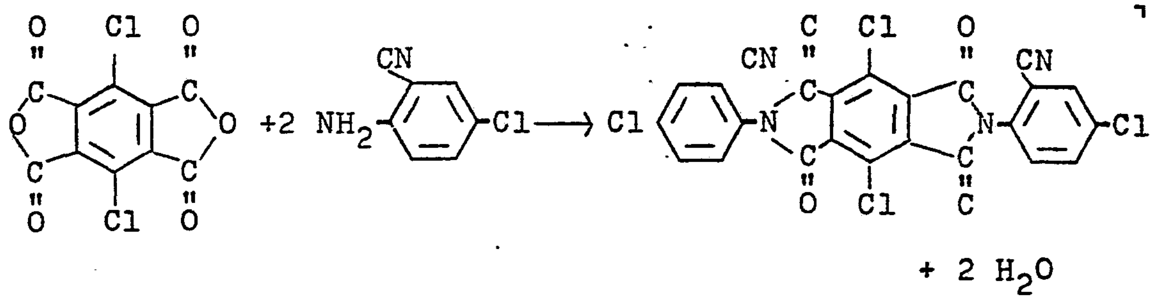

## Beispiel 1

Aus dem beim Versuch 1 erhaltenen Reaktionsprodukt wurde eine 5%ige Lösung in einem Gemisch aus 2 Volumenteilen Methylenchlorid und 1 Volumenteil Toluol hergestellt. 50 ml dieser Lösung wurden mit 50 ml einer 2 % enthaltenen Lösung von Poly-N-Vinylcarbazol in dem vorstehend genannten Lösungsmittelgemisch, vermengt, wobei eine braune Mischung entstand. Unter Verwendung eines Drahtrakels, einem Edelstahlstab mit einem Durchmesser von 5 mm, auf dem ein Draht mit dem Durchmesser von 0,5 mm aufgewickelt war, wurde die braune Lösung des DA-Komplexes auf einer quadratischen Aluminiumfolie mit der Dicke 40 /um in den Abmessungen 12,5 auf 12,5 cm verstrichen. Vor der Beschichtung war diese Aluminiumfolie mit Sandpapier aufgerauht worden. Die mit der erfindungsgemäßen fotoleitfähigen Masse beschichtete Folie wurde 1 Stunde lang bei Zimmertemperatur und anschließend noch 1 Stunde bei ungefähr 115°C im Trockenschrank getrocknet. Der Verbund aus Aluminiumfolie und erfindungsgemäßer fotoleitfähiger Masse wurde bei 23°C und 55 % relativer Luftfeuchtigkeit 24 Stunden gelagert, bevor die nachstehend beschriebenen Messungen vorgenommen wurden, wobei als Ergebnis festgehalten werden soll, daß als Halbwertszeit des Ladungsabflusses : 0,25 Sekunden gemessen wurde und die Feldstärke-Differenz zwischen "Dunkel- und Restladung" 5200 $\frac{V/m}{g}$ betrug.

Beispiele 2 bis 12

Wie in Beispiel 1 beschrieben, wurden in einem Gemisch aus Methylenchlorid und Benzol im Volumenverhältnis 2 : 1 die in nachfolgender Liste näher bezeichneten Sensibilisatoren Nr. 2-12 mit Poly-N-Vinylcarbazol-Lösungen gemischt. Für die aus den Lösungen von Kunststoff und Sensibilisator erhaltenen Filme wurden nach der Ladung die Dunkelfeldstärke sowie die Halbwertszeit des Ladungsabflusses in der nachfolgend beschriebenen Versuchsanordnung bestimmt. Die Ergebnisse dieser Versuche sind in der Tabelle enthalten. In der Tabelle ist ebenfalls die Zusammensetzung der erfindungsgemäßen Massen (Verhältnis Sensibilisator/Kunststoff) angegeben; außerdem ist die Fotoleitfähigkeit von 2,4,7-Trinitro-9-fluorenon mit aufgeführt.

Die in den Beispielen 1 und 2 bis 12 beschriebenen Folien wurden jeweils nach dem von W. Hübler, Elektrotechnik 53, 1971, Seite 10 bis 15 beschriebenen Verfahren gleichmäßig elektrostatisch aufgeladen. Hierzu wurden die Folien bzw. die Verbunde aus elektrisch leitender Unterlage und Folie jeweils auf eine metallische Lochplatte gelegt, durch Erzeugen eines Unterdrucks plan auf dieser ausgerichtet und auf einem Schlitten mit einem Vorschub von 13 sec/120 mm an einer mit 7,5 kV betriebenen Sprühelektrode vorbeigeführt und aufgeladen. Anschließend passierte der Schlitten eine berührungsfrei arbeitende Meßelektrode. Die Meßelektrode war mit Durchbrüchen versehen; hinter den Durchbrüchen befand sich ein Raum, in dem ein durch einen Rotor angetriebener Metallflügel untergebracht war. Die die Meßelektrode durchsetzenden Kraftlinien erzeugten in dem vorgenannten Raum ein elektrostatisches Feld; dadurch trat im Rotor eine Spannung auf, die der erregenden Feldstärke proportional war. Mit Hilfe eines Schreibers (Papiervorschub 600 mm/Min.) wurde der Versuchsverlauf registriert.

Unter der Meßelektrode wurde der Schlitten angehalten. Eine Glühbirne mit einer Leistung von 60 W, die in einer Entfernung von ca. 10 cm über und in einem Abstand von 10 cm vom Rand der Aluminiumfolie angebracht war, wurden die Folien bzw. Verbunde jeweils 3 sec. lang belichtet. Zunächst wurde zu Beginn des Versuchs eine elektrostatische Ladung auf der Folie bzw. dem Verbund erzeugt, die als Feldstärke in V/m gemessen wurde. Im Dunkeln nahm die Feldstärke etwas ab, bis sich ein etwas niedrigerer Gleichgewichtswert einstellte (Dunkelfeldstärke). Beim Belichten des Verbundes mit der Glühbirne nahm die Leitfähigkeit des Verbundes spontan zu; die elektrischen Ladungen flossen bis auf eine geringfügige Restladung ab. Es wurde jeweils für die Folien der Beispiele die Halbwertszeit für den Abfluß der Ladungen von dem vorstehend genannten "Gleichgewichtswert im Dunkeln" bis auf den "Restladungsanteil" bestimmt. Die Ergebnisse dieser Messungen sind in der Tabelle aufgeführt. Die "Gleichgewichtsfeldstärke im Dunkeln" (in V/m) ist bezogen auf $g/m^2$, d.h. sie hat die Dimension V.m/g. Sie ist in der Tabelle angegeben. Die Halbwertszeit ist in Sekunden angegeben. Für die meisten Sensibilisatoren wurden bis zu 4 Messungen bei unterschiedlichem Anteil des Sensibilisators, bezogen auf Poly-N-Vinylcarbazol, durchgeführt.

Tabelle

| Sensibilisator von Bsp. Nr. | Anteil des Sensibilisators in Mol% | $\frac{V.m}{g}$ | t 1/2 |
|---|---|---|---|
| 2 | 2,91 | 7211,5 | 0,2 |
| | 5,66 | 6704,0 | 0,25 |
| | 8,26 | 5897,2 | 0,25 |
| | 50 | 10533,3 | 0,41 |
| 3 | 2,91 | 5022,3 | 0,2 |
| | 5,66 | 6597,2 | 0,3 |
| | 8,26 | 6750,0 | 0,2 |
| | 50 | 13409,1 | 0,64 |
| 4 | 2,91 | - | 0,3 |
| | 5,66 | 6406,3 | 0,3 |
| | 8,26 | 7465,3 | 0,35 |
| | 50 | 14227,3 | 0,38 |
| 5 | 2,91 | 39062,5 | 0,35 |
| | 5,66 | 3472,2 | 0,2 |
| | 8,26 | 2990,3 | 0,25 |
| | 50 | 12850,0 | 1,78 |
| 6 | 2,91 | 2884,6 | 0,15 |
| | 5,66 | 3281,3 | 0,2 |
| | 8,26 | 2636,7 | 0,15 |
| | 50 | 6250,0 | 1,36 |
| 7 | 2,91 | 8062,5 | 0,2 |
| | 5,66 | 8789,1 | 0,25 |
| | 8,26 | 7875,0 | 0,15 |
| | 50 | 10363,6 | 0,3 |
| 8 | 2,91 | 3335,3 | 0,15 |
| | 5,66 | 2604,2 | 0,15 |
| | 8,26 | 5062,5 | 0,20 |
| | 50 | 12280,0 | 0,35 |
| 9 | 2,91 | 1841,5 | 0,1 |
| | 5,66 | 3879,3 | 0,2 |
| | 8,26 | 4513,9 | 0,2 |
| | 50 | 11916,7 | 0,45 |
| 10 | 50 | 91,1 | 0,3 |
| 11 | 50 | 5239,2 | 0,95 |
| 12 | 50 | 418,0 | 0,45 |

Fortsetzung Tabelle

| Sensibilisator von Bsp. Nr. | Anteil des Sensibilisators in Mol% | $\frac{V \cdot m}{g}$ | t 1/2 |
|---|---|---|---|
| Trinitrofluorenon | 2,91 | 5889,2 | 0,1 |
| | 5,66 | 4783,6 | 0,1 |
| | 8,26 | 2382,5 | 0,1 |
| | 50 | 4431,4 | 0,2 |

Liste der Sensibilisatoren

| Beispiel | | |
|---|---|---|
| 2 | Tetrachlor-perylen-3,4,9,10-tetracarbonsäuredianhydrid | |
| 3 | " | di-N-methylimid |
| 4 | " | di-N-(äthoxicarbonylmethylen)-imid |
| 5 | " | diimid |
| 6 | " | di-N-hydroxiimid |
| 7 | Hexachlor-perylen-3,4,9,10-tetracarbonsäuredianhydrid | |
| 8 | Dibrom-perylen-3,4,9,10-tetracarbonsäuredi-N-(äthoxicarbonylmethylen)-imid | |
| 9 | Hexabrom-perylen-3,4,9,10-tetracarbonsäuredi-N-(4-chlor-2-cyanophenyl)-imid | |
| 10 | Dichlor-perylen-3,4,9,10-tetracarbonsäure-tetramethylester | |
| 11 | Pentachlor-perylen-3,4,9,10-tetracarbonsäure-tetramethylester | |
| 12 | Dichlor-perylen-3,4,9,10-tetracarbonsäure-tetrahydroxiäthylester | |

## Patentansprüche

1. Fotoleitfähige Massen, enthaltend

   a) Homopolymerisate von N-Vinylcarbazol oder dessen kernsubstituierten Halogen-, Alkyl-, Alkoxy- oder Dialkylaminoderivaten oder Mischungen daraus und/oder Copolymerisate mit bis zu 30 Gewichtsprozent an mit N-Vinylcarbazol copolymerisierbaren Monomeren,

   b) Sensibilisatoren, sowie

   c) gegebenenfalls weitere Zusätze,

   dadurch gekennzeichnet, daß diese Massen als Sensibilisatoren von durch ein oder mehrere Halogenatome, Nitril- und/oder Nitrogruppen substituierten carbocyclischen aromatischen Grundkörpern abgeleitete
   $b_1$-Polyanhydride mit mindestens 2 Anhydridgruppen,
   $b_2$-Ester von diesen und/oder
   $b_3$-davon abgeleitete Imide, die gegebenenfalls am (an den) Stickstoffatom(en) durch $C_1$-$C_8$-Alkyl-, $C_1$-$C_8$-Alkoxy-, $C_1$-$C_8$-Alkyloxycarbonylalkyl substituiert sind.

2. Massen nach 1, dadurch gekennzeichnet, daß die Sensibilisatoren als aromatischen Grundkörper Benzol, Naphthalin oder Perylen aufweisen.

3. Verwendung der Massen gemäß Anspruch 1. Zur Herstellung von Filmen oder Verbunden.

0009742

Europäisches Patentamt

# EUROPÄISCHER RECHERCHENBERICHT

Nummer der Anmeldung

EP 79 10 3585

| EINSCHLÄGIGE DOKUMENTE | | | KLASSIFIKATION DER ANMELDUNG (Int.Cl. 3) |
|---|---|---|---|
| Kategorie | Kennzeichnung des Dokuments mit Angabe, soweit erforderlich, der maßgeblichen Teile | betrifft Anspruch | |
| | US - A - 3 928 035 (D.J. CURTIN)<br>* Ansprüche; Spalte 2, Zeilen 26-55 *<br>-- | 1-3 | G 03 G 5/09<br>H 01 L 31/02 |
| A | DE - A - 2 059 540 (KALLE)<br>* Ansprüche; Seite 2, Abschnitt 1; Beispiele ; Figuren *<br>-- | 1-3 | |
| A | RESEARCH DISCLOSURE, Nr. 163, November 1977, Seiten 61-62; Art. Nr. 16349. Hampshire (GB) W.E. YOERGER et al. "Halogenated chemical sensitizers for organic photoconductive compositions".<br>* Seite 61, Spalte 1, Abschnitt 4 bis Seite 61, Spalte 2, Abschnitt 1; Seite 61, Spalte 2, letzter Abschnitt; Seite 62, Spalte 1, Beispiel 2 *<br>-- | 1-3 | RECHERCHIERTE SACHGEBIETE (Int. Cl. 3)<br>G 03 G 5/09<br>H 01 L 31/02 |
| A | GB - A - 1 092 618 (IBM)<br>* Ansprüche; Seite 2, Zeilen 86-98; Seite 3, Zeilen 11-40; die Beispiele. *<br>-- | 1-3 | KATEGORIE DER GENANNTEN DOKUMENTE<br>X: von besonderer Bedeutung<br>A: technologischer Hintergrund<br>O: nichtschriftliche Offenbarung<br>P: Zwischenliteratur<br>T: der Erfindung zugrunde liegende Theorien oder Grundsätze<br>E: kollidierende Anmeldung<br>D: in der Anmeldung angeführtes Dokument<br>L: aus andern Gründen angeführtes Dokument |
| A | FR - A - 1 463 728 (RANK XEROX)<br>* Die Zusammenfassung; Seite 4, Spalte 2, Abschnitt 1 *<br>-- | 1-3 | |
| A | FR - A - 2 361 749 (BASF)<br>* Ansprüche; Seite 1, Zeile 10 bis Seite 3, Zeile 11 *<br>---- | 1-3 | &: Mitglied der gleichen Patentfamilie, übereinstimmendes Dokument |
| X | Der vorliegende Recherchenbericht wurde für alle Patentansprüche erstellt. | | |

| Recherchenort | Abschlußdatum der Recherche | Prüfer |
|---|---|---|
| Den Haag | 09-01-1980 | VANHECKE |